# EUROPÄISCHE PATENTSCHRIFT

(11) **EP 3 729 624 B1**
(45) Veröffentlichungstag und Bekanntmachung des Hinweises auf die Patenterteilung: **02.06.2021**
(21) Anmeldenummer: 18825635.8
(22) Anmeldetag: 14.12.2018
(51) Int. Cl.: H02M 1/32, H02M 1/36, H02J 3/38, H02J 7/34, H02M 1/00, H02M 7/5387

(54) **VERFAHREN ZUR KONDENSATORENTLADUNG FUER EINE WECHSELRICHTERANORNDUNG**
METHOD FOR CAPACITOR DISCHARGING FOR AN INVERTER ASSEMBLY
PROCÉDÉ DE DÉCHARGE DE CONDENSATEUR POUR ENSEMBLE FORMANT ONDULEUR

(30) Priorität: 21.12.2017 DE 102017130882
(43) Veröffentlichungstag der Anmeldung: 28.10.2020
(73) Patentinhaber: SMA Solar Technology AG, 34266 Niestetal (DE)
(72) Erfinder: STEIPER, Florian, 34199 Kassel (DE); GEHRKE, Christian, 34127 Kassel (DE)
(86) Internationale Anmeldenummer: PCT/EP2018/084994
(87) Internationale Veröffentlichungsnummer: WO 2019/121405

(56) Entgegenhaltungen:
- DE-A1-102004 057 693
- US-A1- 2015 202 967

## Beschreibung

Die Erfindung betrifft ein Verfahren zum Entladen eines Kondensators einer Eingangs- oder Ausgangsschaltungsanordnung eines Wechselrichters zum Einspeisen von Strom in ein Energieversorgungsnetz. Die Erfindung betrifft weiterhin einen Wechselrichter mit einer Steuereinrichtung, der zur Durchführung des Verfahrens geeignet ist.

Netzgekoppelte Wechselrichter werden in Energieversorgungsanlagen, beispielsweise Photovoltaikanlagen und Windenergieanlagen, eingesetzt. Bei einem derartigen Wechselrichter folgt eine am Ausgang des Wechselrichters ausgegebene Spannung bzw. ein ausgegebener Strom dem entsprechenden Verlauf im Energieversorgungsnetz.

Bei einer Photovoltaikanlage (PV-Anlage) erzeugt ein Photovoltaikgenerator (PV-Generator), der aus einer Mehrzahl von Photovoltaikmodulen in einer Serien- und/oder Parallelschaltung aufgebaut sein kann, eine Gleichspannung, die - ggf. nach einer Spannungsänderung durch einen Hochsetzsteller - einem Zwischenkreis mit Zwischenkreiskondensator des Wechselrichters zugeführt wird. Gleichspannung aus dem Zwischenkreis wird von einer Brückenanordnung des Wechselrichters in einen bezüglich seiner Frequenz und Spannung zur Einspeisung in das Energieversorgungsnetz geeigneten Wechselstrom umgewandelt. Diese Umwandlung kann dabei in einen ein- oder mehrphasigen, insbesondere dreiphasigen Wechselstrom erfolgen. Zur Umwandlung des Gleichstroms (DC - direct current) in Wechselstrom (AC - alternating current) weist der Wechselrichter eine Brückenanordnung mit zwei oder mehr Schaltbrücken auf, die üblicherweise mit Leistungshalbleiterschaltern bestückt sind, die in bestimmten Modulationsmustern angesteuert werden. In Verbindung mit Filtern, die am Ausgang des Wechselrichters angeordnet sind, wird ein möglichst sinusförmiger Ausgangsstrom erzeugt.

Aus Sicherheitsgründen ist es gewünscht oder auch normativ gefordert, dass an Anschlüssen eines ein- und/oder ausgangsseitig getrennten Wechselrichters keine gefährdenden Spannungen mehr anliegen.

Die zuvor genannten ausgangsseitigen Filter des Wechselrichters, die der Formung eines möglichst sinusförmigen Stromverlaufs und gegebenenfalls einer EMV-Filterung (Elektromagnetische-Verträglichkeit-Filterung) dienen, umfassen Spulen und insbesondere auch Kondensatoren, die zwischen einem Nullleiter und einem Phasenleiter oder zwischen zwei Phasenleitern angeordnet sind. Auch wenn der Wechselrichter nicht mehr betrieben wird, können diese Kondensatoren aufgeladen sein, was zu gefährlich hohen Spannungen an Ausgangsleitungen führen kann.

Aus der Druckschrift WO 2010/133532 A2 ist ein Wechselrichter bekannt, der einen Gleichrichter mit nachgeschaltetem Gleichspannungswandler (DC/DC-Wandler) zur Stromversorgung von Elektronikkomponenten des Wechselrichters aufweist. Gemäß dieser Druckschrift wird ein ausgangsseitiger Kondensator eines Filters des Wechselrichters über den Gleichrichter und den nachgeschalteten DC/DC-Wandler entladen

Die Druckschrift US 2015/202967 A1 offenbart ein Verfahren zum Entladen eines Kondensators einer Eingangsschaltungsanordnung eines Wechselrichters, wobei die Ladung in einen zweiten Kondensator - einen Zwischenkreistransformator - transferiert wird.

Häufig weisen Wechselrichter DC/DC-Wandler auch im Leistungspfad auf, um eine vom PV-Generator gelieferte Spannung an die von der Brückenanordnung benötigte Spannung anpassen zu können. Ein solcher DC/DC-Wandler kann auch zur Leistungsoptimierung eingesetzt werden, derart, dass die Betriebsspannung der PV-Generatoren über eine Variation des Spannungsübertragungsverhältnisses des DC/DC-Wandlers möglichst in einem optimalen Betriebspunkt (MPP - Maximum Power Point) gehalten wird. Ein derartiger, in der Regel als Hochsetzsteller arbeitender DC/DC-Wandler weist in seinen Eingangsschaltungen ebenfalls Kondensatoren auf, die nach Trennung des Wechselrichters vom PV-Generator noch geladen sein können und die Eingangsanschlüsse des Wechselrichters beaufschlagen. Aus Sicherheitsgründen ist eine Entladung auch derartiger Kondensatoren gewünscht oder gefordert, wenn der PV-Generator vom Wechselrichter getrennt ist. Dazu ist es beispielsweise bekannt, nach einem Feststellen der Trennung des PV-Generators von den Eingangsanschlüssen des Wechselrichters die genannten Kondensatoren über dauerhaft parallel zu Kondensatoren geschaltete oder hinzuschaltbare Widerstände zu entladen. Das Feststellen der Trennung des PV-Generators vom Wechselrichter sowie die Widerstände und ggf. Schaltorgane zum zeitweisen Verbinden der Widerstände führen zu einem konstruktiven Mehraufwand bei dem Wechselrichter. Sind die Widerstände dauerhaft mit den Kondensatoren verbunden, tritt Verlustleistung auf, die in dem oder den Widerständen in Wärme umgesetzt wird.

Es ist eine Aufgabe der vorliegenden Erfindung, ein Verfahren zum Betreiben eines Wechselrichters zu schaffen, bei dem ohne zusätzlichen konstruktiven Aufwand des Wechselrichters ein Entladen von ein- oder ausgangsseitigen Kondensatoren des Wechselrichters möglich ist, ohne dass Energieverluste auftreten, die eine Energieeffizienz des Wechselrichters beinträchtigen.

Diese Aufgabe wird durch ein Verfahren bzw. einen Wechselrichter mit den Merkmalen des jeweiligen unabhängigen Anspruchs gelöst. Vorteilhafte Ausgestaltungen und Weiterbildungen sind Gegenstand der abhängigen Ansprüche.

Ein erfindungsgemäßes Verfahren zum Entladen eines Kondensators einer Eingangs- oder Ausgangsschaltungsanordnung eines Wechselrichters zur Einspeisung von Strom in ein Energieversorgungsnetz umfasst die folgenden Schritte: Es wird eine Anschlussspannung an Anschlüssen der Eingangs- oder Ausgangsschaltungsanordnung ermittelt. Dann wird eine Zwischenkreisspannung eines Zwischenkreiskondensators des Wechselrichters ermittelt und es wird ein oberer Grenzspannungswert des Zwischenkreiskondensators anhand der gemessenen Anschlussspannung und der gemessenen Zwischenkreisspannung bestimmt. Ein eingangsseitiger DC/DC-Wandler oder eine ausgangsseitige Brückenanordnung des Wechselrichters wird derart betrieben, dass Energie aus dem Kondensator der Eingangs- oder Ausgangsschaltungsanordnung in den Zwischenkreiskondensator übertragen wird, wobei die Spannung am Zwischenkreiskondensator überwacht wird. Das Verfahren wird beendet, falls der obere Grenzspannungswert überschritten wird. Andernfalls wird das Verfahren fortgeführt, indem weiter Energie aus dem Kondensator der Eingangs- oder Ausgangsschaltungsanordnung in den Zwischenkreiskondensator übertragen wird, bis der Kondensator bis auf oder unter einen unteren Grenzspannungswert entladen ist.

Es wird somit z.B. unter Berücksichtigung der (bekannten) Kapazitäten des zu entladenden Kondensators und des Zwischenkreiskondensators ermittelt, welche Spannung der Zwischenkreiskondensator annehmen würde, wenn die Ladung des Kondensators der Eingangs- oder Ausgangsschaltungsanordnung in den Zwischenkreiskondensator übertragen würde. Unter Spannungsüberwachung der Zwischenkreisspannung wird dann die Ladungsübertragung vorgenommen. Wird der ermittelte Maximalwert erreicht, ohne dass die Ein- bzw. Ausgangspannung auf oder unter den unteren Grenzspannungswert gesunken ist, wird das Verfahren beendet und ermöglicht die Aussage, dass der Wechselrichter noch nicht vom PV-Generator bzw. dem Energieversorgungsnetz getrennt war. Andernfalls steht nach Beendigung des Verfahrens fest, dass der Wechselrichter tatsächlich vom PV-Generator bzw. dem Energieversorgungsnetz getrennt war. In dem Fall ist gleichzeitig bereits der Kondensator der Ein- bzw. Ausgangsschaltungsanordnung entladen.

In einer vorteilhaften Ausgestaltung des Verfahrens ist der obere Grenzspannungswert eine berechnete Spannung, die sich ergibt, wenn die gesamte Ladung des Kondensators der Eingangs- oder Ausgangsschaltungsanordnung verlustfrei in den Zwischenkreiskondensator übertragen werden würde. Entsprechend ist vorteilhaft nach dem Erreichen des oberen Grenzspannungswertes der Kondensator im Wesentlichen vollständig entladen.

Es kann dabei zusätzlich ein positiver Offsetspannungswert zu der berechneten Spannung addiert werden, um den oberen Grenzspannungswert zu bestimmen. Dieser zusätzliche Offsetspannungswert verhindert einen vorzeitigen Abbruch des Verfahrens, der sich z.B. durch Abweichungen einer tatsächlichen von einer angenommenen Kapazität ergibt.

In einer weiteren vorteilhaften Ausgestaltung des Verfahrens ist der zu entladende Kondensator ein Energiespeicher des eingangsseitigen DC/DC-Wandlers, wobei der DC/DC-Wandler zum Entladen des Kondensators als Hochsetzsteller betrieben wird. In diesem Fall wird durch das Verfahren erreicht, die Eingangsseite nach Trennung von einem PV-Generator spannungsfrei zu bekommen.

In einer weiteren vorteilhaften Ausgestaltung des Verfahrens ist der zu entladende Kondensator ein ausgangsseitiges Filterelement, wobei die Brückenanordnung zum Entladen des Kondensators als Hochsetzsteller betrieben wird. Hierdurch wird entsprechend verhindert, dass am Ausgang des Wechselrichters noch eine Spannung nach Trennung von einem Energieversorgungsnetz anliegt.

Bevorzugt wird der untere Grenzspannungswert als eine ungefährliche Kleinspannung gewählt, um sicherzustellen, dass die Ein- bzw. Ausgänge des Wechselrichters gefahrlos berührt werden können.

In einer weiteren vorteilhaften Ausgestaltung des Verfahrens wird ein Signal ausgegeben, wenn das Verfahren aufgrund eines Überschreitens des oberen Grenzspannungswerts beendet wird. Das Signal gibt an, wenn das Verfahren erfolglos beendet werden musste. Es kann als Warnsignal dienen oder als Steuersignal, um das Verfahren nach einer Wartezeit, in der die bereits vom Zwischenkreis aufgenommene Energie abgebaut wird, erneut zu starten.

Ein erfindungsgemäßer Wechselrichter weist einen eingangsseitigen DC/DC-Wandler, einen Zwischenkreis mit einem Zwischenkreiskondensator und eine ausgangsseitige Brückenanordnung auf, sowie eine Steuereinrichtung zur Ansteuerung von Halbleiterschaltorganen des DC/DC-Wandlers und/oder der Brückenanordnung. Der Wechselrichter zeichnet sich dadurch aus, dass die Steuereinrichtung zur Durchführung eines der zuvor beschriebenen Verfahren eingerichtet ist. Es ergeben sich die im Zusammenhang mit den Verfahren genannten Vorteile.

Die Erfindung wird nachfolgend anhand von Ausführungsbeispielen mit Hilfe von Figuren nähert erläutert. Die Figuren zeigen:
- Fig. 1: ein schematisches Blockschaltbild eines Wechselrichters; und
- Fig. 2: ein Flussdiagramm eines Verfahrens zum Entladen eines Kondensators eines Wechselrichters.

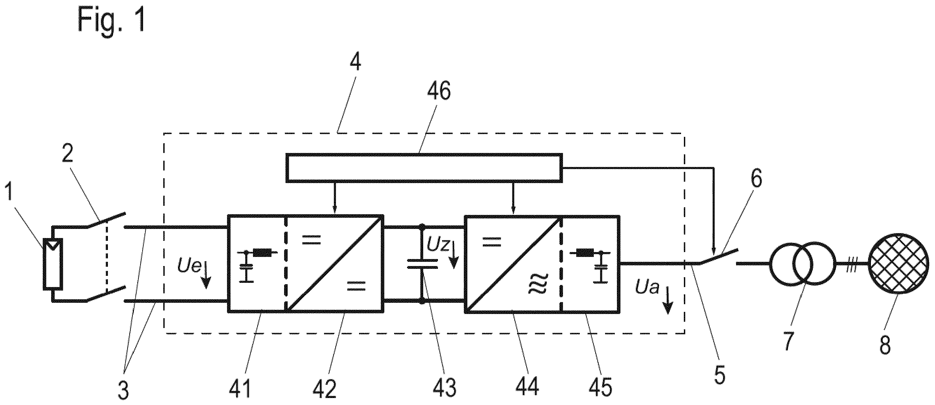

Fig. 1 zeigt eine Photovoltaikanlage (PV-Anlage) als Energieversorgungsanlage in einem schematischen Blockschaltbild verbunden mit einem Energieversorgungsnetz 8.

Die PV-Anlage weist einen Photovoltaikgenerator (PV-Generator) 1 auf, der über einen Gleichspannungs- (DC-) Trennschalter 2 und Eingangsleitungen 3 mit einem Wechselrichter 4 verbunden ist. Der Wechselrichter 4 wiederum ist mit einer Ausgangsleitung 5 über einen Wechselspannungs- (AC-) Trennschalter 6 und einen (optionalen) Transformator 7 mit dem Energieversorgungsnetz 8 verbunden.

Symbolhaft ist in Fig. 1 der PV-Generator 1 nur durch das Schaltsymbol einer einzelnen Photovoltaikzelle dargestellt. Es versteht sich, dass der PV-Generator 1 in einer Umsetzung der dargestellten PV-Anlage aus einer Mehrzahl von Photovoltaikmodulen (PV-Modulen) aufgebaut sein kann, die serien- und/oder parallelverschaltet sind.

Der Wechselrichter 4 umfasst im dargestellten Ausführungsbeispiel einen eingangsseitigen DC/DC-Wandler 42 der über einen Zwischenkreis, aufweisend einen Zwischenkreiskondensator 43, mit einer Brückenanordnung 44 verbunden ist. Die Brückenanordnung 44 bildet mit zwei oder mehr Schaltbrücken einen DC/AC-Wandler. Der Zwischenkreiskondensator 43 dient der Glättung einer Zwischenkreisspannung Uz und ermöglicht eine gepulste Stromentnahme durch die Brückenanordnung 44 ohne Spannungseinbrüche der Zwischenkreisspannung Uz

Der dem Zwischenkreis vorgeschaltete DC/DC-Wandler 42 ermöglicht eine Anpassung der Spannung des PV-Generators 1 an die gewünschte Zwischenkreisspannung Uz, die im Betrieb der Brückenanordnung 44 durch eine Scheitelspannung im Energieversorgungsnetz vorgegeben ist. Durch den DC/DC-Wandler 42 kann die Spannung des PV-Generators 1 in weiten Grenzen variiert werden, ohne dass die Zwischenkreisspannung Uz von dem gewünschten Wert abweicht. Die Spannung am Eingang des DC/DC-Wandlers 42 wird nachfolgend als Eingangsspannung Ue bezeichnet. Die Spannung des PV-Generators 1 kann beispielsweise im Rahmen eines Optimierungsverfahrens, z.B. eines MPP-Nachführverfahrens, variiert werden, wodurch der PV-Generator 1 nach Möglichkeit an einem Arbeitspunkt maximaler Leistung betrieben wird.

In der Regel ist der DC/DC-Wandler 42 als ein Hochsetzsteller ausgebildet, der die vom PV-Generator 1 gelieferte Spannung auf den gegenüber der Eingangsspannung Ue höheren Spannungswert der Zwischenkreisspannung Uz wandelt. Zur Hochsetzstellung werden Energiespeicher in Form (mindestens) eines Kondensators und einer Spule eingesetzt, die symbolisch in der Eingangsschaltungsanordnung 41 dargestellt sind. Diese typische Eingangsschaltungsanordnung 41 mit dem gezeigten Kondensator führt dazu, dass an den Eingangsanschlüssen bzw. den Eingangsleitungen 3 auch dann eine Spannung anliegen kann, wenn der DC-Trennschalter 2 geöffnet ist.

Am Ausgang der Brückenanordnung 44 befindet sich eine Ausgangsschaltungsanordnung 45, die ebenfalls Kondensatoren und ggf. Induktivitäten aufweist und die als Filter dient, um den von der Brückenanordnung 44 gepulst abgegebenen Strom zu glätten. Eine solche Ausgangsschaltungsanordnung 45 wird häufig auch als Sinusfilter bezeichnet. Auch bei der Ausgangsschaltungsanordnung 45 besteht die Gefahr, dass der entsprechende Ausgangsanschluss und die Ausgangsleitung 5 mit Spannung beaufschlagt sind, auch wenn sie durch den AC-Trennschalter 6 vom Energieversorgungsnetz 8 abgekoppelt sind.

Beim dargestellten Ausführungsbeispiel ist die Brückenanordnung 44 ebenso wie alle nachgeordneten Komponenten dreiphasig ausgelegt. Es versteht sich, dass die Brückenanordnung 44 und entsprechend die nachfolgenden Komponenten auch eine beliebige, insbesondere kleinere Zahl von Phasen aufweisen können.

Der Wechselrichter 4 weist weiter eine Steuereinrichtung 46 auf, die unter anderem sowohl den DC/DC-Wandler 42, als auch die Brückenanordnung 44 ansteuert. Unter einem Ansteuern des DC/DC-Wandlers 42 und der Brückenanordnung 44 ist insbesondere ein zeitgesteuertes Ein- und Ausschalten (Takten) von Halbleiterschaltorganen des DC/DC-Wandlers 42 und/oder der Brückenanordnung 44 zu verstehen. Durch entsprechendes Takten dieser Halbleiterschaltorgane kann sowohl ein Spannungsübersetzungsverhältnis zwischen dem Eingang und dem Ausgang des jeweiligen Wandlers 42, 44, als auch eine Energieflussrichtung beeinflusst werden.

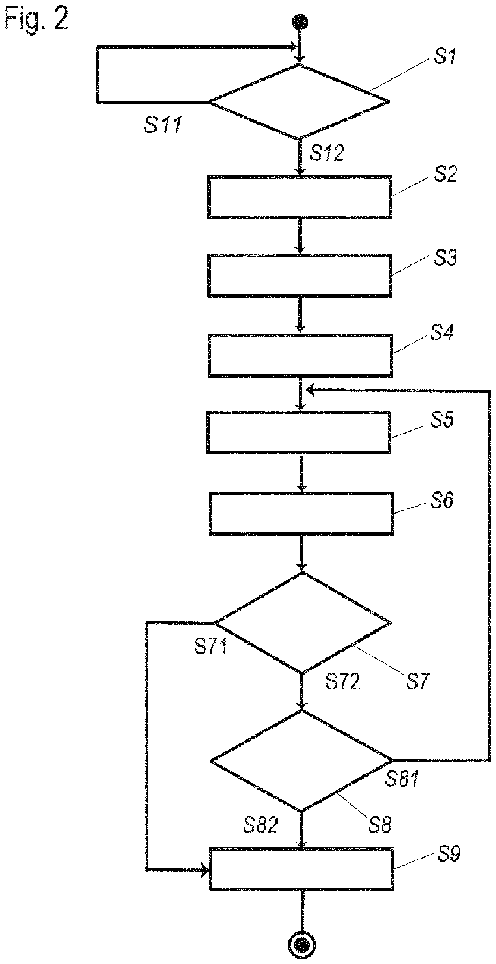

In Fig. 2 ist ein Betriebsverfahren zum Entladen eines Kondensators einer Eingangs- oder Ausgangsschaltungsanordnung eines Wechselrichters in Form eines Flussdiagramms dargestellt. Beispielhaft wird das Verfahren mit Bezug auf die in Fig. 1 gezeigte PV-Anlage beschrieben.

Es wird davon ausgegangen, dass zu Beginn des Verfahrens sich der Wechselrichter in einem Einspeisebetrieb befindet. Als Einspeisebetrieb ist ein Betrieb zu verstehen, bei dem der PV-Generator 1 Leistung in Form von Gleichstrom abgibt, die durch den Wechselrichter 4 in Wechselstromleistung gewandelt wird und in das Energieversorgungsnetz 8 eingespeist wird.

In einem ersten Schritt S1 des Verfahrens wird überprüft, ob der Wechselrichter Leistung einspeist. Zu diesem Zweck sind im Wechselrichter, beispielsweise innerhalb der Brückenanordnung 44, Strom- und/oder Spannungssensoren angeordnet, die von der Steuereinrichtung 46 ausgelesen werden können. Wird im Schritt S1 festgestellt, dass der Wechselrichter noch Leistung einspeist (Fall S11) verzweigt das Verfahren zurück, und führt den Schritt S1 erneut aus. Speist der Wechselrichter keine Leistung mehr ein (Fall S12) verzweigt das Verfahren zu einem nächsten Schritt S2.

Ein Grund dafür, dass der Wechselrichter keine Leistung mehr einspeist, kann darin liegen, dass der PV-Generator 1 vom Wechselrichter 4 abgekoppelt wurde, beispielsweise in einem Brandfall oder zu Wartungszwecken. In diesen Fällen wurde beispielsweise der DC-Trennschalter 2 geöffnet. Nachdem im Schritt S1 festgestellt wurde, dass der Wechselrichter keine Leistung mehr einspeist, ist dann dafür Sorge zu tragen, dass die Eingangsanschlüsse des Wechselrichters 4, an denen die Eingangsleitungen 3 angeschlossen sind, spannungsfrei sind.

Mit den sich im dargestellten Verfahren anschließenden Schritten wird ermittelt, ob der PV-Generator 1 noch mit dem Wechselrichter verbunden ist und ggf. der Kondensator der Eingangsschaltungsanordnung 41 entleert.

In dem Schritt S2 wird zu diesem Zweck zunächst die Eingangsspannung Ue des Wechselrichters 4 und die Zwischenkreisspannung Uz am Zwischenkreiskondensator 43 des Wechselrichters 4 gemessen.

In einem nachfolgenden Schritt S3 wird ein oberer Grenzspannungswert Umax aus den im Schritt S2 eingelesenen Werten bestimmt, und zwar als die Spannung, die am Zwischenkreiskondensator 43 anliegen würde, wenn die gesamte Ladung des Kondensators der Eingangsschaltungsanordnung 41 zu der bereits im Zwischenkreiskondensator 43 enthaltenen Ladung umgeladen würde, ohne dass Ladungen bzw. Ströme anderweitig ab- oder zufließen. Diese Berechnung kann bei Kenntnis der Kapazitäten des Kondensators der Eingangsschaltungsanordnung 41 und des Zwischenkreiskondensators 43 und dem bekannten Zusammenhang zwischen Ladung und Spannung eines Kondensators bei gegebener Kapazität erfolgen. Im Rahmen der Berechnung kann der obere Grenzspannungswert Umax gegenüber dem Berechnungswert um einen positiven Offset erhöht werden, beispielsweise um bis zu einige 10 Volt. Dies dient dazu, bei dem nachfolgend erläuterten Schritt S7 die Wahrscheinlichkeit eines fälschlichen Abbruchs des Verfahrens zu verhindern.

In einem nächsten Schritt S4 wird der DC/DC-Wandler 42 aktiviert und ein Durchfahren einer Spannungsrampe für die Spannung am Eingang des Wechselrichters vorbereitet. Die Spannungsrampe hat eine negative Steigung, verläuft also zu kleineren Eingangsspannungen hin bis zu dem Zielwert "0 Volt". Das Durchlaufen der Spannungsrampe erfolgt in einem nachfolgenden Schritt S5, wobei der DC/DC-Wandler 42 als Hochsetzsteller so betrieben wird, dass die Ladung des Kondensators der Eingangsschaltungsanordnung 41 in den Zwischenkreiskondensator 43 übertragen wird. Entsprechend wird sich die Spannung der Eingangsschaltungsanordnung 41 permanent erniedrigen, falls die Eingangsschaltungsanordnung 41 tatsächlich vom PV-Generator 1 abgekoppelt ist.

In einem folgenden Schritt S6 werden die Eingangsspannung Ue und die Zwischenkreisspannung Uz wiederum (vergleichbar zum Schritt S2) eingelesen.

In einem sich anschließenden Schritt S7 und einem sich daran anschließenden Schritt S8 erfolgt eine Überprüfung der im Schritt S6 gemessenen Spannungen, und zwar indem zunächst im Schritt S7 überprüft wird, ob die Zwischenkreisspannung Uz den im Schritt S3 berechneten oberen Grenzspannungswert Umax überschreitet.

Falls die Zwischenkreisspannung die berechnete Spannung Umax überschreitet (Fall S71) verzweigt das Verfahren zu einem Schritt S9, in dem der DC/DC-Wandler 42 deaktiviert wird. Das Erreichen oder Überschreiten der maximalen Spannung Umax zeigt, dass der PV-Generator 1 nicht vom Wechselrichter 4 abgekoppelt ist, weswegen mehr Ladung als von der Eingangsschaltungsanordnung 41 gespeichert werden kann, in den Zwischenkreiskondensator 43 transferiert wurde. Das Entladen des Kondensators der Eingangsschaltungsanordnung 41 kann somit in diesem Betriebszustand der PV-Anlage nicht erfolgen, weswegen das Verfahren ohne eine Entladung des Kondensators abgebrochen wird.

Nach einem Abbruch des Verfahrens besteht die Möglichkeit, dieses nach einer gewissen Wartezeit erneut zu starten, um es dann ggf. zu einem erfolgreichen Abschluss zu bringen. Dies kann beispielsweise erforderlich sein, wenn zwischenzeitlich der Wechselrichter 4 vom PV-Generator 1 abgekoppelt wurde. Während der Wartezeit ist der Zwischenkreiskondensator 43 zu entladen, beispielsweise indem die von ihm gespeicherte Energie in ein Bordnetz des Wechselrichters 4, das der Eigenversorgung des Wechselrichters 4 dient, abgegeben wird. Die genannte Wartezeit kann vorgegeben sein oder auch durch Messung der Zwischenkreisspannung Uz ermittelt werden. Das Verfahren wird dann erneut gestartet, wenn die Zwischenkreisspannung Uz auf oder unter einen vorgegebenen Wert abgesunken ist.

Falls im Schritt S7 der FallS71 nicht eingetreten ist, also im Fall S72, wird in dem nächsten Schritt S8 überprüft, ob die Eingangsspannung Ue unter einen unteren Grenzspannungswert Umin gefallen ist. Dieser untere Grenzspannungswert Umin ist so klein gewählt, dass eine unterhalb liegende Spannung als ungefährlich angesehen werden kann. Sie liegt beispielsweise im Bereich von <30 V.

Falls dieser untere Grenzspannungswert Umin an den Eingangsanschlüssen noch nicht erreicht ist (Fall S81) verzweigt das Verfahren zurück zum Schritt S5, d.h. der DC/DC-Wandler 42 transferiert weiter Ladung vom Kondensator der Eingangsschaltungsanordnung 41 in den Zwischenkreiskondensator 43 und die Eingangsspannung Ue und die Zwischenkreisspannung Uz werden gemessen und erneut verglichen. Durch die so gebildete Schleife im Verfahrensablauf wird der Ladungstransfer in den Zwischenkreiskondensator 43 (quasi) permanent überwacht.

Falls im Schritt S8 festgestellt wird, dass die Eingangsspannung Ue unter den unteren Grenzspannungswert Umin gefallen ist (Fall S82) wird das Verfahren ebenfalls mit dem Schritt S9 beendet. In diesem Fall wurde durch das Verfahren erkannt, dass der PV-Generator 1 nicht mehr mit dem Wechselrichter 4 verbunden ist und gleichzeitig wurde bereits der Kondensator der Eingangsschaltungsanordnung 41 entladen.

In vergleichbarer Weise kann das in Fig. 2 gezeigte Verfahren eingesetzt werden, um eine Spannung am Ausgang des Wechselrichters 4, also beispielsweise auf der Ausgangsleitung 5, auf oder unter einen ungefährlichen Wert zu bringen, der kleiner als der untere Grenzspannungswert Umin ist.

Ausgangslage für ein solches Verfahren ist beispielsweise, dass die Wechselspannung im Energieversorgungsnetz 8 wegfällt, z.B. aufgrund eines Zusammenbruchs einer oder mehrerer Phasen im Energieversorgungsnetz 8. Der Wechselrichter 4 stellt nach dem Erkennen einer solchen Situation den Einspeisebetrieb ein. Bevor aber über den AC-Trennschalter 6 der Wechselrichter 4 vom Energieversorgungsnetz 8 getrennt wird, sollte sichergestellt sein, dass Ausgangsanschlüsse keine Spannung mehr aufweisen. Es könnte sein, dass Kondensatoren der Ausgangsschaltungsanordnung 45 noch geladen sind, so dass eine möglicherweise gefährdende Spannung am Ausgang des Wechselrichters 4 anliegt. Auch könnte eine hohe Spannung am Ausgang des Wechselrichters 4 zu einer Beschädigung von elektrischen Verbrauchern führen, die z.B. nach einem Auslösen einer Hauptsicherung eines Wohnhauses zum Energieversorgungsnetz 8 noch mit dem Wechselrichter 4 verbunden sind.

Es wird dann vergleichbar mit dem Schritt S2 in dem zuvor beschriebenen Verfahren die Ausgangsspannung Ua sowie die Zwischenkreisspannung Uz gemessen und, wieder unter Berücksichtigung der bekannten Kapazitäten, ein oberer Grenzspannungswert Umax gemäß dem Schritt S3 berechnet, der sich ergeben würde, wenn die gesamte Ladung der oder des Kondensators der Ausgangsschaltungsanordnung 45 in den Zwischenkreiskondensator 43 übertragen würde.

Anschließend wird, vergleichbar mit den Schritten S4 und S5, die Brückenanordnung 44 so betrieben, dass ein Ladungs- und Leistungstransfer vom Ausgang zum Eingang der Brückenanordnung 44, also zum Zwischenkreis hin erfolgt. Wiederum werden, vergleichbar zum Schritt S6, die Zwischenkreisspannung Uz sowie die Spannung des zu entleerenden Kondensators, hier also die Spannung Ua des Kondensators der Ausgangsschaltungsanordnung 45, eingelesen. In einem folgenden Schritt wird analog zum Schritt S7 überprüft, ob die Spannung des Zwischenkreiskondensators 43 den berechneten oberen Grenzspannungswert Umax übersteigt (Fall S71).

Wird der Fall S71 erkannt, wird in einem nächsten Schritt analog zum Schritt S9 der Betrieb der Brückenanordnung 44 eingestellt, um zu verhindern, dass die Spannung im Zwischenkreis immer weiter steigt, weil beispielsweise ein Netzfehler im Energieversorgungsnetz 8 fälschlicherweise detektiert wurde. Es wird auf diese Weise verhindert, dass der Zwischenkreiskondensator 43 Schaden nimmt.

Falls der Fall S71 im Schritt S7 nicht eintritt, wird das Verfahren so lange weiter geführt (Fall S72) bis die Kondensatoren in der Ausgangsschaltungsanordnung 45 auf eine Spannung gebracht sind, die kleiner als der untere Grenzspannungswert Umin ist (analog zu Schritt S8, Fall S82), woraufhin das Verfahren erfolgreich beendet wird. In diesem Fall kann die Taktung der Brückenanordnung 44 eingestellt werden. Anschließend kann der AC-Trennschalter 6 geöffnet werden und der Wechselrichter 4 von dem Energieversorgungsnetz 8 getrennt werden.

### Bezugszeichen

- 1: PV-Generator
- 2: DC-Trennschalter
- 3: Eingangsleitung
- 4: Wechselrichter
- 41: Eingangsschaltungsanordnung
- 42: DC/DC-Wandler
- 43: Zwischenkreiskondensator
- 44: Brückenanordnung
- 45: Ausgangsschaltungsanordnung
- 46: Steuereinrichtung
- 5: Ausgangsleitung
- 6: AC-Trennschalter
- 7: Transformator
- 8: Energieversorgungsnetz

- Ue: Anschlussspannung am Eingang (Eingangsspannung)
- Ua: Anschlussspannung am Ausgang (Ausgangsspannung)
- Uz: Zwischenkreisspannung

- S1-S9: Verfahrensschritte

- S11, S12, S71, S72, S81, S82: Fall

## Patentansprüche

1. Verfahren zum Entladen eines Kondensators einer Eingangs- oder Ausgangsschaltungsanordnung (41, 45) eines Wechselrichters (4) zur Einspeisung von Strom in ein Energieversorgungsnetz (8), mit den folgenden Schritten:
- Ermitteln einer Anschlussspannung (Ue, Ua) an Anschlüssen der Eingangs- oder Ausgangsschaltungsanordnung (41, 45);
- Ermitteln einer Zwischenkreisspannung (Uz) eines Zwischenkreiskondensators (43) des Wechselrichters (4);
- Berechnen eines oberen Grenzspannungswerts (Umax) des Zwischenkreiskondensators (43) anhand der gemessenen Anschlussspannung (Ue, Ua) und der gemessenen Zwischenkreisspannung (Uz);
- Betreiben eines eingangsseitigen DC/DC-Wandlers (42) oder einer ausgangsseitigen Brückenanordnung (44) des Wechselrichters (4) derart, dass Energie aus dem Kondensator der Eingangs- oder Ausgangsschaltungsanordnung (41, 45) in den Zwischenkreiskondensator (43) übertragen wird, wobei die Spannung am Zwischenkreiskondensator (43) überwacht wird;
- Beenden des Verfahrens, falls der obere Grenzspannungswert (Umax) überschritten wird, und andernfalls
- Fortführen des Übertragens der Energie aus dem Kondensator der Eingangs- oder Ausgangsschaltungsanordnung (41, 45) in den Zwischenkreiskondensator (43) bis der Kondensator bis auf oder unter einen unteren Grenzspannungswert (Umin) entladen ist.

2. Verfahren nach Anspruch 1, bei dem der obere Grenzspannungswert (Umax) eine berechnete Spannung ist, die sich ergibt, wenn die gesamte Ladung des Kondensators der Eingangs- oder Ausgangsschaltungsanordnung (41, 45) verlustfrei in den Zwischenkreiskondensator (43) übertragen würde.

3. Verfahren nach Anspruch 2, bei dem zusätzlich ein positiver Offsetspannungswert zu der berechneten Spannung addiert wird, um den oberen Grenzspannungswert (Umax) zu bestimmen.

4. Verfahren nach einem der Ansprüche 1 bis 3, wobei der zu entladende Kondensator ein Energiespeicher des eingangsseitigen DC/DC-Wandlers (42) ist, und wobei der DC/DC-Wandler (42) zum Entladen des Kondensators als Hochsetzsteller betrieben wird.

5. Verfahren nach einem der Ansprüche 1 bis 3, wobei der zu entladende Kondensator ein ausgangsseitiges Filterelement ist, und wobei die Brückenanordnung (44) zum Entladen des Kondensators als Hochsetzsteller betrieben wird.

6. Verfahren nach einem der Ansprüche 1 bis 5, bei dem der untere Grenzspannungswert (Umin) einer ungefährlichen Kleinspannung entspricht.

7. Verfahren nach einem der Ansprüche 1 bis 6, bei dem ein Signal ausgegeben wird, wenn das Verfahren aufgrund eines Überschreitens des oberen Grenzspannungswerts (Umax) beendet wird.

8. Wechselrichter (4) mit einem eingangsseitigen DC/DC-Wandler (42), einem Zwischenkreis mit einem Zwischenkreiskondensator (43) und einer ausgangsseitigen Brückenanordnung (44), sowie einer Steuereinrichtung (46) zur Ansteuerung von Halbleiterschaltorganen des DC/DC-Wandlers (42) und/oder der Brückenanordnung (44), **dadurch gekennzeichnet, dass** die Steuereinrichtung (46) zur Durchführung eines Verfahrens gemäß einem der Ansprüche 1 bis 7 eingerichtet ist.

## Claims

1. A method for discharging a capacitor of an input or output circuit arrangement (41, 45) of an inverter (4) for supplying current to a power supply grid (8), having the following steps:
- determining a supply voltage (Ue, Ua) at connections of the input or output circuit arrangement (41, 45);
- determining a DC link voltage (Uz) of a DC link capacitor (43) of the inverter (4);
- calculating an upper limit voltage value (Umax) of the DC link capacitor (43) on the basis of the measured supply voltage (Ue, Ua) and the measured DC link voltage (Uz);
- operating an input-side DC/DC converter (42) or an output-side bridge arrangement (44) of the inverter (4) such that energy from the capacitor of the input or output circuit arrangement (41, 45) is transferred to the DC link capacitor (43), wherein the voltage across the DC link capacitor (43) is monitored;
- ending the method if the upper limit voltage value (Umax) is exceeded, and otherwise
- continuing to transfer the energy from the capacitor of the input or output circuit arrangement (41, 45) to the DC link capacitor (43) until the capacitor is discharged to or below a lower limit voltage value (Umin).

2. The method as claimed in claim 1, in which the upper limit voltage value (Umax) is a calculated voltage obtained if all of the charge of the capacitor of the input or output circuit arrangement (41, 45) were transferred to the DC link capacitor (43) without loss.

3. The method as claimed in claim 2, in which a positive offset voltage value is additionally added to the calculated voltage in order to determine the upper limit voltage value (Umax).

4. The method as claimed in any one of claims 1 to 3, wherein the capacitor to be discharged is an energy store of the input-side DC/DC converter (42), and wherein the DC/DC converter (42) is operated as a step-up converter to discharge the capacitor.

5. The method as claimed in any one of claims 1 to 3, wherein the capacitor to be discharged is an output-side filter element, and wherein the bridge arrangement (44) is operated as a step-up converter to discharge the capacitor.

6. The method as claimed in any one of claims 1 to 5, in which the lower limit voltage value (Umin) corresponds to a safe low voltage.

7. The method as claimed in any one of claims 1 to 6, in which a signal is output if the method is ended on account of the upper limit voltage value (Umax) being exceeded.

8. An inverter (4) having an input-side DC/DC converter (42), a DC link having a DC link capacitor (43) and an output-side bridge arrangement (44), and also a control device (46) for actuating semiconductor switching elements of the DC/DC converter (42) and/or the bridge arrangement (44), **characterized in that** the control device (46) is configured to perform a method as claimed in any one of claims 1 to 7.

## Revendications

1. Procédé de décharge d'un condensateur de configuration de circuit d'entrée ou de sortie (41, 45) d'un onduleur (4) pour fournir de l'énergie à un réseau d'alimentation électrique (8), comprenant les étapes suivantes :
- Déterminer une tension de raccordement (Ue, Ua) aux bornes de la configuration de circuit d'entrée ou de sortie (41, 45) ;
- Déterminer une tension du circuit intermédiaire (Uz) d'un condensateur du circuit intermédiaire (43) de l'onduleur (4) ;
- Calculer une valeur de tension limite supérieure (Umax) du condensateur du circuit intermédiaire (43) sur la base de la tension de raccordement mesurée (Ue, Ua) et de la tension de circuit intermédiaire mesurée (Uz) ;
- Faire fonctionner un convertisseur DC/DC (42) côté entrée ou un montage en pont côté sortie (44) de l'onduleur (4) de telle sorte que de l'énergie soit transférée du condensateur de la configuration de circuit d'entrée ou de sortie (41, 45) dans le condensateur de circuit intermédiaire (43), la tension aux bornes du condensateur de circuit intermédiaire (43) étant surveillée ;
- Terminer le procédé si la valeur de tension limite supérieure (Umax) est dépassée, et sinon
- Continuer à transférer de l'énergie du condensateur de la configuration de circuit d'entrée ou de sortie (41, 45) au condensateur du circuit intermédiaire (43) jusqu'à ce que le condensateur soit déchargé à une valeur de tension limite inférieure (Umin) ou en dessous de celle-ci.

2. Procédé selon la revendication 1, dans lequel la valeur de tension limite supérieure (Umax) est une tension calculée qui résulterait si la totalité de la charge du condensateur de la configuration de circuit d'entrée ou de sortie (41, 45) était transférée dans le condensateur de circuit intermédiaire (43) sans perte.

3. Procédé selon la revendication 2, dans lequel une valeur de tension de décalage positive est en outre ajoutée à la tension calculée pour déterminer la valeur de tension limite supérieure (Umax).

4. Procédé selon l'une des revendications 1 à 3, dans lequel le condensateur à décharger est un dispositif de stockage d'énergie du convertisseur DC/DC (42) côté entrée, et dans lequel le convertisseur DC/DC (42) est exploité comme un convertisseur élévateur pour décharger le condensateur.

5. Procédé de l'une des revendications 1 à 3, dans lequel le condensateur à décharger est un élément de filtre côté sortie, et dans lequel le montage en pont (44) fonctionne comme un convertisseur élévateur pour décharger le condensateur.

6. Procédé de l'une des revendications 1 à 5, dans lequel la valeur de tension limite inférieure (Umin) correspond à une basse tension non dangereuse.

7. Procédé de l'une des revendications 1 à 6, dans lequel un signal est émis lorsque le procédé est terminé en raison du dépassement de la valeur de tension limite supérieure (Umax).

8. Onduleur (4) comportant un convertisseur DC/DC (42) côté entrée, un circuit intermédiaire comportant un condensateur de circuit intermédiaire (43) et un montage en pont (44) côté sortie, et un dispositif de commande (46) pour commander des éléments de commutation à semi-conducteurs du convertisseur DC/DC (42) et/ou du montage en pont (44), **caractérisé en ce que** le dispositif de commande (46) est conçu pour exécuter un procédé selon l'une des revendications 1 à 7.
